# EUROPEAN PATENT SPECIFICATION

(11) **EP 4 477 328 B1**
(45) Date of publication and mention of the grant of the patent: **21.01.2026**
(21) Application number: 23179407.4
(22) Date of filing: 15.06.2023
(51) Int. Cl.: B06B 1/06, H10N 30/20

(54) **MICROMECHANICAL ULTRASONIC TRANSDUCER FOR ULTRASONIC WAVE GENERATION OR ULTRASONIC WAVE DETECTION AND METHOD OPERATING THE ULTRASONIC TRANSDUCER**
MIKROMECHANISCHER ULTRASCHALLWANDLER ZUR ULTRASCHALLWELLENERZEUGUNG ODER ULTRASCHALLWELLENDETEKTION UND VERFAHREN ZUM BETRIEB DES ULTRASCHALLWANDLERS
TRANSDUCTEUR ULTRASONORE MICROMÉCANIQUE POUR LA GÉNÉRATION D'ONDES ULTRASONORES OU LA DÉTECTION D'ONDES ULTRASONORES ET PROCÉDÉ DE FONCTIONNEMENT DU TRANSDUCTEUR ULTRASONORE

(43) Date of publication of application: 18.12.2024
(73) Proprietor: Silicon Austria Labs GmbH, 8010 Graz (AT)
(72) Inventor: XU, Tingzhong, 9500 Villach (AT)
(74) Representative: Wirnsberger & Lerchbaum Patentanwälte OG

(56) References cited:
- CN-A- 114 513 729
- US-A1- 2017 021 391
- US-A1- 2022 193 722
- US-A1- 2023 009 789

## Description

The invention concerns a micromechanical ultrasonic transducer for ultrasonic wave generation or ultrasonic wave detection, wherein the ultrasonic transducer comprises a diaphragm and at least one actuator for the emission or detection of ultrasound, wherein the actuator is designed to transfer between an elastic deformation, in particular a vibration, of the diaphragm and an electrical control signal corresponding to each other. The invention further concerns a method of operating a micromechanical ultrasonic transducer.

Furthermore, the invention concerns a method of manufacturing a micromechanical ultrasonic transducer.

Piezoelectric micromechanical ultrasonic transducers, also referred to as PMUT, are known from the prior art, for example for use as range sensors. These are typically MEMS-based piezoelectric ultrasonic transducers. Generally, PMUTs comprise a vibratable diaphragm for generating and/or detecting ultrasonic waves, the diaphragm being formed with two electrodes and a piezoelectric thin film disposed between the electrodes for generating bending vibrations of the diaphragm. The diaphragm is typically disposed over a cavity of the ultrasonic transducer.

Measurement methods using PMUTs have advantages over optical measurement methods both in terms of robustness of a measurement, for example when used in dusty environments, and in terms of energy efficiency. However, PMUTs often have limitations in terms of output capacity, sensitivity, linearity and directivity, especially if these are to be of high quality simultaneously.

Document CN 114 513 729 A relates to a micromechanical transducer with several cantilevers arranged around a diaphragm, with slots between the adjacent cantilevers being covered with an elastic seal.

It is an object of the invention to provide a micromechanical ultrasonic transducer that has an improved operational capability.

A further object of the invention is to provide a method of operating a micromechanical ultrasonic transducer that has an improved operational capability.

Furthermore, it is an object of the invention to provide a method of manufacturing a micromechanical ultrasonic transducer which has an improved operational capability.

To achieve the foregoing objects, the invention provides a micromechanical ultrasonic transducer for ultrasonic wave generation or ultrasonic wave detection, wherein the ultrasonic transducer comprises a diaphragm and at least one actuator for the emission or detection of ultrasound, wherein the actuator is designed to transfer between an elastic deformation, in particular a vibration, of the diaphragm and an electrical control signal corresponding to each other, wherein the diaphragm comprises a coupling plate and a plurality of cantilevers arranged around the coupling plate, wherein the cantilevers are connected to the coupling plate, preferably via spring elements, usually so that with elastic deformation of the cantilevers a vibration of the coupling plate can be excited.

The invention is based on the idea to design the diaphragm such that a non-linearity of a vibration excitation caused by a fixed boundary of the diaphragm is reduced. If the diaphragm is formed with a coupling plate, which is usually arranged substantially centrally in the diaphragm, and a plurality of cantilevers, usually so that with, in particular controlled, elastic deformation of the cantilevers a vibration of the coupling plate can be excited, a stress-reduced structure, in particular with respect to the cantilevers, and a highly, in particular substantially, boundary released structure, in particular with respect to the coupling plate, can be realized. This applies particularly if the cantilevers are connected to the coupling plate via, particularly by, spring elements. A non-linearity of the vibration excitation of the diaphragm can thus be greatly reduced. In this way, a vibration of the coupling plate with a piston-like vibration mode, particularly at a first resonant frequency of the diaphragm, can be achieved. Particularly, high output sensitivity and high output capacitance, especially in a linear operating range, can be achieved in this way. For ease of reading, micromechanical ultrasonic transducer is abbreviated as ultrasonic transducer and/or transducer, so that these designations are to be understood as synonyms for the micromechanical ultrasonic transducer.

Usually, in top view of the diaphragm, the cantilevers are arranged adjacent to each other, particularly side by side, along a circumference around the coupling plate. Expediently, the at least one actuator may be coupled to the cantilevers, particularly mechanically. The at least one actuator may be configured to transfer between an elastic deformation, in particular vibration, of the cantilevers and an electrical control signal corresponding to each other. The transducer may comprise several such actuators. The respective cantilever can be coupled with an actuator, in particular an own actuator, in order to transfer between an elastic deformation, in particular vibration, of the cantilever and an electrical control signal corresponding to each other.

Typically, the diaphragm, particularly in a non-excited state of the diaphragm, is arranged in a fictive arrangement surface, in particular a fictive arrangement plane. Top view usually refers to a top view of the diaphragm, particularly of the fictive arrangement surface, in particular orthogonal to the arrangement surface. The diaphragm, especially the cantilevers and the coupling plate usually represent a sensing surface of the transducer, for detecting or generating an ultrasonic sound wave with the sensing surface. The diaphragm is usually held freely suspended with, particularly by, the cantilevers, particularly via the spring elements.

The respective cantilever may have a first end facing away from the coupling plate and a second end facing the coupling plate. The second end is usually connected to the coupling plate, particularly by a spring element. Thus, a very wide linear working range and/or a very high output capacity can be achieved. This can be explained by a very high degree of a boundary release of the diaphragm, especially of the coupling plate. The first end is usually connected, in particular arranged, usually fixed, to an anchor structure. The respective cantilever can be connected to the anchor structure by the first end of the cantilever and can be connected to the coupling plate by the second end of the cantilever, particularly by a spring element. The respective cantilever, particularly its first end and/or second end, is usually connected to the anchor structure and/or the coupling plate such that with elastic deformation of the cantilevers a vibration of the coupling plate can be excited. The first end may be arranged fixed in position, particularly fixed, with respect to a vibration of the diaphragm. Typically, the second end is arranged to be movable, particularly capable of vibration, relative to the first end and/or relative to the anchor structure. Usually, the first end of the respective cantilever is arranged in an edge region of the diaphragm and the second end of the respective cantilever is arranged in an inner region of the diaphragm. The spring elements can be part of a single, in particular monolithic spring structure, or the spring elements can each be implemented as individualized structural elements, in particular individualized spring elements. The respective cantilever may be connected to the coupling plate by exactly one or more spring elements, in particular its own. Respectively, a first end portion of the spring element may be arranged at the second end of the cantilever and a second end portion of the spring element, which particularly is opposite to the first end portion at the spring element, may be arranged at the coupling plate. The spring element can be formed so that, with elastic deformation of the spring element, a relative movability, in particular a constrained relative movability, is provided between the cantilever and the coupling plate, especially in a direction orthogonal to a connecting axis defined by the spring element which runs from the cantilever to the coupling plate. The relative movability may be a relative tilting movability and/or a relative torsional movability. The spring element may be a rod-shaped spring element. A connecting axis defined with the respective spring element, which connects the respective cantilever, particularly its second end, to the coupling plate, can be oriented angularly, usually with an acute angle, to an extension direction from the first end to the second end of the cantilever. The foregoing, particularly with respect to an arrangement or shape, especially regarding the cantilevers and/or the spring element, can apply in top view.

In top view, the respective cantilever may have a curved, particularly arcuate, shape, especially a shape of a spiral segment. The shape may refer to a center line of the cantilever extending from the first end to the second end of the cantilever. The cantilevers, particularly the second ends, and/or the spring elements may be connected to the coupling plate in top view along a circumference around the coupling plate at, particularly regular, distances from each other. The diaphragm may have at least two, at least three, at least four, at least five or at least six cantilevers.

The cantilevers can be arranged in the fictive arrangement surface, particularly fictive arrangement plane. In top view, the cantilevers are usually separated from each other by slits. The diaphragm typically has a plurality of slits, the slits defining an outer contour of the cantilevers, the coupling plate, and in particular the spring elements. The cantilevers, especially together with the coupling plate, may form a close-packed arrangement. This applies in particular in top view. The slits are typically slits of the diaphragm. Usually, the slits extend entirely through the diaphragm in a depth direction of the slits. Typically, the respective slit has a substantially constant thickness along its longitudinal extent. The thickness is usually measured orthogonally to the longitudinal extent of the slit. The longitudinal extent is usually parallel to the arrangement surface. The slit may have a thickness smaller than 50 µm, particularly smaller than 15 µm, preferably smaller than 5 µm, more preferably smaller than 1 µm. The thickness is usually greater than 10 nm. Several, particularly all, of the slits may have a substantially equal thickness. Usually, the depth direction is substantially a top view direction of the top view of the diaphragm. Typically, the respective cantilever, particularly the second end, may be deflected relative to the anchor structure to cause the cantilever to vibrate. The deflection is typically an elastic mechanical deflection. An ultrasonic wave is usually generated with the diaphragm by vibrating the cantilever and the coupling plate. A detection of an ultrasonic wave impinging on the diaphragm is usually done in that the cantilevers and the coupling plate are vibrated by the ultrasonic wave.

The anchor structure is typically formed with a base body of the transducer. Typically, the respective cantilever protrudes from the base body so that the cantilever is deflectable to perform vibration. The first end and the second end of the respective cantilever are typically opposite ends of the cantilever, particularly in a direction parallel to the arrangement surface. Usually, the cantilever is tapered in an extension direction from the first end to the second end. The extension direction is typically oriented parallel to the arrangement surface. Particularly, a width extension of the cantilever may decrease along the extension direction. The diaphragm is usually flexible. The base body is usually rigid. The foregoing applies usually in a top view of the diaphragm, particularly the arrangement surface.

The respective cantilever is usually plate-shaped. A longitudinal extension and a width extension of the respective cantilever are usually oriented parallel to the arrangement surface. The cantilevers are usually arranged in the arrangement surface. Typically, the cantilevers are separated from each other by slits, so that the cantilevers can be deflected and/or vibrated, particularly individually, for the conversion of an ultrasonic wave. The respective slit is usually located in the arrangement surface. A shape of the cantilevers and/or the coupling plate and/or, if present, the spring elements is usually essentially determined by a course of the slots. The conversion of an ultrasonic wave may be a generation or detection of an ultrasonic wave. The vibration of the cantilevers is typically a mechanical vibration, particularly a bending vibration. The vibration usually corresponds to a deflection of the respective cantilever. A deflection of the respective cantilever usually occurs orthogonally to the arrangement surface. In general, the cantilevers have the same shape. The shape usually refers to an outer contour of the respective cantilever in top view of the diaphragm, in particular the arrangement surface.

In the invention, in top view along a circumference around the coupling plate, adjacent cantilevers overlap each other in sections in the radial direction of the coupling plate. In this way, accurate vibration control can be achieved. This has been shown to be favorable for generating a strongly pronounced piston-like vibration mode, particularly at a first resonant frequency of the diaphragm. Typically, in top view, the respective cantilever is tapered in shape from the first end to the second end of the cantilever.

The respective cantilever can be coupled to an actuator, particularly mechanically coupled, wherein the actuator is designed to transfer between an elastic deformation, in particular vibration, of the cantilever and an electrical control signal corresponding to each other. The respective actuator may be part of the cantilever. The actuator is usually coupled to the cantilever, particularly mechanically, so that the deflection, in particular vibration, of the cantilever corresponds to the electrical control signal. The actuator may be configured to cause a vibration of the cantilever corresponding to an electrical control signal applied to the actuator to generate an ultrasonic wave with the diaphragm. Alternatively or cumulatively, the actuator may be configured to generate an electrical control signal corresponding to a vibration of the cantilever for sensing an ultrasonic wave with the diaphragm. The respective cantilever may be coupled to, particularly comprise, a plurality of such actuators.

The coupling plate can be coupled to an actuator, particularly mechanically coupled, wherein the actuator is designed to transfer between an elastic deformation, in particular vibration, of the coupling plate and an electrical control signal corresponding to each other. The respective actuator may be part of the coupling plate. The actuator is usually coupled to the coupling plate, particularly mechanically, so that the deflection, in particular vibration, of the coupling plate corresponds to the electrical control signal. The actuator may be configured to cause a vibration of the coupling plate corresponding to an electrical control signal applied to the actuator to generate an ultrasonic wave with the diaphragm. Alternatively or cumulatively, the actuator may be configured to generate an electrical control signal corresponding to an vibration of the coupling plate for sensing an ultrasonic wave with the diaphragm. The coupling plate may be coupled to, particularly comprise, a plurality of such actuators.

If the cantilevers and the coupling plate are each drivable with their own actuators, a particularly high output sensitivity can be achieved. This applies especially to a vibration mode at a first resonance frequency of the diaphragm, which is usually a lowest resonance frequency of the diaphragm. In particular, the vibration mode at the first resonant frequency of the diaphragm may have a piston shape, typically with respect to a velocity distribution along the diaphragm. Especially, a vibration mode, typically at the first resonant frequency, with a very large volumetric vibration velocity can be achieved. This applies in particular if the cantilevers and coupling plate are connected to each other via spring elements.

The ultrasonic wave can be generated with the transducer by causing acoustic pressure fluctuations by a vibration of the diaphragm, in particular the cantilevers and/or the coupling plate. The ultrasonic wave can be detected with the transducer by acoustic pressure fluctuations causing a vibration of the diaphragm, in particular the cantilevers and/or the coupling plate. The acoustic pressure fluctuations can relate to a medium adjacent to the diaphragm, particularly a gaseous medium, for example air.

The electrical control signal is usually an electrical alternating signal. The electrical signal can be an electrical voltage signal, in particular an AC voltage signal, or an electrical current signal, in particular an AC current signal. The respective actuator is usually electrically connected to an electrical control line in order to apply the electrical control signal to the actuator or output it with the actuator via the electrical control line. The electrical control lines may be part of the transducer.

The respective actuator may be formed as part of the diaphragm, particularly of the respective cantilever or the respective coupling plate. The respective actuator may be arranged in an interior and/or on a surface of the diaphragm, in particularly of the respective cantilever or the coupling plate. The respective actuator may be a piezoelectric actuator, an electrostatic actuator, a nanoscopic-electrostatic-drive (NED) actuator, or an electromagnetic actuator. The piezoelectric actuator is usually designed to transfer between the vibration and the electrical control signal by means of piezoelectric effect.

The electrostatic actuator is usually designed to transfer between the vibration and the electrical control signal by means of piezoelectric effect. The piezoelectric actuator may be formed with two electrodes and a piezoelectric material arranged between the electrodes, usually in the form of a piezoelectric layer, so that a piezoelectric element is formed to convert with the piezoelectric element between a respective control signal and the vibration corresponding to the control signal, particularly of the diaphragm, preferably of the respective cantilever or the coupling plate. The electromagnetic actuator is usually designed to transfer between the vibration and the electrical control signal by means of an electromagnetic field. The electromagnetic actuator can be formed with a, particularly planar, coil, wherein with the respective control signal, particularly in the form of a control current, a magnetic field is generated with the coil in order to cause a vibration, usually of the diaphragm, preferably of the cantilever or the coupling plate, with an electromagnetic force caused by the magnetic field. The electrostatic actuator and/or the nanoscopic-electrostatic-drive actuator can be designed to transfer between the vibration and the electrical control signal by means of an electrostatic field. The electrostatic actuator and/or the nanoscopic-electrostatic-drive actuator can be designed to generate an electrostatic field with the control signal in order to cause a vibration, particularly of the diaphragm, preferably of the cantilever or the coupling plate, with an electrostatic force caused by the electrostatic field. For example, the electrostatic actuator may have an electrical conductor plate to generate the electrostatic field.

Practicable control is achievable if the respective actuator is formed with a piezoelectric element, particularly as a piezoelectric element. The actuator is then usually referred to as a piezoelectric actuator. The piezoelectric element can then be used to convert between the vibration of the diaphragm, particularly of the respective cantilever or coupling plate, and the respective electrical control signal. The respective actuator, in particular its piezoelectric element, can be connected to the respective cantilever or coupling plate, particularly formed as part thereof, such that a vibration of the cantilever or coupling plate corresponds to a, in particular elastic, deformation, usually mechanical vibration, of the piezoelectric element, in particular its piezoelectric layer. Thus, an electrical control signal corresponding to the vibration can be output with the piezoelectric element and/or a vibration of the cantilever corresponding to the electrical control signal can be caused by applying an electrical control signal to the piezoelectric element.

The actuator may be formed with a piezoelectric arrangement to form the piezoelectric element. Typically, the piezoelectric arrangement is formed with two electrical electrodes and a piezoelectric layer disposed between the electrical electrodes. The piezoelectric arrangement, may be formed with at least three piezoelectric layers arranged on each other, wherein the piezoelectric layers are arranged between two electric electrodes and an electric electrode is arranged between each two adjacent ones of the piezoelectric layers. This is favorable for a high signal-to-noise ratio. The piezoelectric arrangement may be formed with more than three such arranged piezoelectric layers. The electrical electrodes and the one or more piezoelectric layers of the piezoelectric arrangement are typically arranged on top of each other in an arrangement direction orthogonal to the arrangement surface. One or more, in particular all, of the electrical electrodes of the piezoelectric arrangement may be electrically connected to electrical control lines for transmitting the electrical control signal. The respective electrical electrode and/or the respective piezoelectric layer may be formed as a thin film. The piezoelectric layer is typically formed of piezoelectric material. The piezoelectric material may be formed with or of, for example, lead zirconate titanate (PZT) or aluminum nitride (AIN). The electrical electrodes are usually formed with or from electrically conductive material, in particular metal, for example platinum, molybdenum, gold or iridium.

The respective actuator can comprise an actuation structure, which actuation structure is movable and/or deformable corresponding to an electrical control signal applied to the actuator, in order to transfer between an elastic deformation, in particular vibration, of the respective cantilever or coupling plate and an electrical control signal corresponding to each other. The actuation structure is usually mechanically connected to or formed as part of the respective cantilever or coupling plate. The actuation structure may be an actuation layer. The actuation structure may be the piezoelectric arrangement, particularly the piezoelectric material, of the piezoelectric actuator.

The respective cantilever and/or the coupling plate may have a structural layer, which typically extends substantially entirely through the respective cantilever and/or the coupling plate. The actuator, in particular the actuation structure, and the structural layer may be arranged on each other, particularly in a direction orthogonal to the arrangement surface. The structural layer may be oriented parallel to the arrangement surface, particularly in a non-use state of the transducer. The respective cantilever and/or coupling plate may each be formed with the actuator, in particular the actuation structure of the actuator. In particular, the respective cantilever and/or the coupling plate may be substantially implemented by the actuator, particularly by the actuation structure. The structural layer is then typically not required. Typically, the cantilever is then implemented substantially entirely by the actuator, in particular the actuation structure In top view, the respective actuator, in particular the actuation structure, for example the piezoelectric arrangement of the respective actuator, may extend over a predominant part of the cantilever or the coupling plate.

The cantilevers can differ in shape and/or size. Preferably, the cantilevers have the same shape and/or the same size. This applies particularly in top view. The cantilevers may be arranged such that the first ends of the cantilevers are part of a circumference around the cantilevers, particularly around the second ends of the cantilevers. The circumference typically lies in the arrangement surface. Usually, the circumference corresponds to a circumference of the diaphragm. The cantilevers may be arranged such that they are transferable into each other by rotation about a rotational axis that is oriented orthogonally to the arrangement surface. Usually, the rotational axis is arranged to intersect the coupling plate. Preferably, the rotational axis runs through a center of the coupling plate.

The actuators may be designed and electrically connected with electrical control lines to output a respective electrical control signal with the respective actuator or to drive the respective actuator with a respective electrical control signal. It may be practicable if the actuators of the cantilevers are electrically coupled to each other in order to output a common electrical control signal or to drive the actuators with a common electrical control signal. For this purpose, electrical control lines, which are electrically connected to the actuators of the cantilevers, can be electrically connected to each other. Usually, the actuators of the cantilevers and the actuator of the coupling plate can be controlled separately from each other with their own electrical control signal.

An actuator of the coupling plate or of a cantilever denotes usually an actuator, which is coupled to the coupling plate or the cantilever, or is a part of the coupling plate or cantilever. The coupling can be implemented as described in this document.

A high compactness can be achieved if the cantilevers together with the slits and the coupling plate are arranged forming a tessellation in the arrangement surface. In top view, longitudinal sides of the respective cantilever can be bounded, particularly substantially entirely, by longitudinal sides of the other cantilevers. Longitudinal sides denote those sides of a respective cantilever which, in top view, extend from the first end to the second end of the respective cantilever. The longitudinal sides are usually separated from each other by slits. In top view, the respective cantilever may have substantially a shape of a triangle or trapezoid, wherein in particular the shape may be deformed, particularly curved, in the direction of extension from the first end to the second end of the cantilever. In top view, the coupling plate may have substantially a corner-free shape, in particular a shape of a circle or an ellipse, or a shape of a regular polygon, for example a shape of a triangle, quadrilateral, pentagon, hexagon.

Usually the diaphragm, in particular the cantilevers and the coupling plate are implemented together, in top view in the form of a circle, an ellipse or a regular polygon. The diaphragm is typically located over a cavity of the transducer. In top view, the cavity is usually located behind the diaphragm. In top view, the cavity is usually covered by the diaphragm, in particularly by the cantilevers including slits and the coupling plate, preferably substantially entirely. A deflection of the diaphragm, in particular the cantilevers and/or coupling plate, upon vibration thereof may occur into the cavity. The diaphragm may delimit the cavity. The diaphragm may define a cavity wall of the cavity. The cavity may be formed with a recess or hollow, particularly open on one side. The cavity may be closed by the diaphragm, in particularly such that the cavity forms the one-sided open cavity. Typically, in top view, the coupling plate and/or a predominant portion, particularly substantially an entirety, of the respective cantilever is located within a cavity rim of the cavity. The cavity rim is usually a rim facing the diaphragm of an opening surface of the cavity covered, especially closed, by the diaphragm. In top view, an area of the coupling plate can be at least 5% and usually at most 75% of an active area of the diaphragm. The active area usually refers to that area of the diaphragm which, especially in top view, is located inside the cavity rim. Usually, the area of the coupling plate, in particular in top view, is from 5% to 75%, in particular from 10% to 60%, preferably from 20% to 50%, in particular preferably from 30% to 45%, of the active area of the diaphragm.

The transducer usually comprises a base body. The diaphragm, in particular a diaphragm edge of the diaphragm, is usually arranged on the base body. The first ends of the cantilevers can each be arranged, particularly fixed, on the base body. The cantilevers can protrude from the base body. In top view, the base body may form a circumference around the second ends of the cantilevers, wherein the first ends of the cantilevers are fixed to the circumference. The base body may be implemented, particularly in top view, with a, especially as, frame structure. The frame structure may form the circumference. The cavity can be formed with the base body. The cantilevers may be arranged on the base body such that the cantilevers project above the cavity and, particularly, the coupling plate is arranged above the cavity, preferably above a center region of the cavity. The cavity may be formed with a recess in the base body or a channel through the base body. This applies particularly in top view.

The base body may be formed with, in particular substantially of, silicon. The anchor structure can be formed with the base body. The first end of the respective cantilever may be fixed to the anchor structure. The anchor structure can have the same structure as the respective cantilever, particularly its first end, so that a structure, in particular a layered structure, of the respective cantilever is extended into the base body. Thus, a great robustness is achievable. The anchor structure may be formed with one or more layers of the base body which are arranged on each other. Particularly, a structural layer and/or piezoelectric layers of the respective cantilever, in particular its actuator, can be extended into the base body. Different ones of the cantilevers may connect to different or the same anchor structure of the base body. The base body may have a substrate on which the anchor structure is arranged. The substrate may be a layer of the base body. The substrate may be formed with, in particular substantially of, silicon. The substrate and the anchor structure may be arranged on each other in a direction orthogonal to the diaphragm or the arrangement surface. The base body may have an electrically insulating insulation layer, which is typically implemented as an oxide layer, between the substrate and the anchor structure. The cavity of the base body can be formed with, especially by, the substrate, particularly together with the oxide layer.

The coupling plate can have a varying mass distribution for inertia balancing, particularly such that in use, in particular upon vibration excitation of the coupling plate, an inner region of the coupling plate with respect to a radial direction of the coupling plate and an outer region of the coupling plate are pivoted in opposite directions, particularly transversal, in particular orthogonally, to a main surface of the coupling plate. In use, the coupling plate may be excited to vibrate, especially with simultaneous tilting deflection of the coupling plate. This may be implemented such that the coupling plate has weight elements projecting from a main structure of the coupling plate. The main structure is typically formed with the structural layer and/or the actuator of the coupling plate. The coupling plate may have first weight elements protruding from the main structure in the normal direction and/or second weight elements protruding from the main structure in the radial direction of the coupling plate. The first weight elements may be arranged on a front side and/or rear side of the coupling plate. The first weight elements are preferably arranged in an edge region of the coupling plate. The second weight elements may form a structured edge region of the coupling plate. Usually, the first weight elements and/or the second weight elements are spaced apart, especially regularly, from each other, in particular along an edge direction of the coupling plate. The rear side of the diaphragm usually denotes a side of the diaphragm facing the substrate and/or the cavity. The front side of the diaphragm usually denotes a side of the diaphragm facing away from the substrate and/or cavity, which is usually opposite the rear side. The top view is usually a view on a side of the diaphragm facing away from the cavity.

The actuators are usually electrically connected to electrical control lines of the transducer to output electrical control signals by the actuators via the control lines for the detection of ultrasonic waves or to apply electrical control signals to the actuators via the control lines for the generation of ultrasonic waves. The micromechanical transducer may comprise an electronic control unit for controlling, particularly regulating, the transducer, in particular the actuators. The control may comprise, especially be, a generation and/or processing of the electrical control signals. Typically, the electronic control unit is connected to the actuators, usually electrically, via the electrical control lines for transmitting electrical control signals between the control unit and the actuators. The electronic control unit may include a microprocessor for controlling and/or processing the electrical control signals. The electrical control signal is typically an alternating electrical signal, particularly an alternating electrical voltage or an alternating electrical current. The electrical control signal typically has one or more frequencies corresponding to resonant frequencies of the respective cantilever and/or coupling plate. The electrical control lines can be arranged and electrically connected to the actuators such that, in particular simultaneously, different actuators can be controlled with different electrical control signals. The vibration of the diaphragm, in particular cantilevers and/or coupling plate, is usually a mechanical vibration, in particular a bending vibration, of the same. A working frequency of the ultrasonic transducer is usually from 40 kHz to 1 MHz, especially when the diaphragm is adjacent to a gaseous external medium, especially air.

A micromechanical ultrasonic transducer array comprising several transducers, in particular such as described in this document, may be provided. Typically, the transducers of the ultrasonic transducer array have a common substrate. Preferably, the diaphragms of the transducers may be arranged in rows or in the form of a closed line on the substrate. The diaphragms may be arranged in a plurality of rows, particularly oriented substantially parallel to each other. The micromechanical ultrasonic transducer array is abbreviated as ultrasonic transducer array and/or transducer array for ease of reading.

The ultrasonic transducer array can be designed such that different transducers can be controlled separately from each other for ultrasonic wave generation or can be read out separately from each other for ultrasonic wave detection. The transducers can each be assigned their own electrical control line, in particular several electrical control lines, in order to apply different electrical control signals for ultrasonic wave generation to the respective diaphragm with the respective electrical control line or to output them for ultrasonic wave detection from the respective diaphragm with the respective electrical control line.

An actuator of a cantilever usually refers to an actuator coupled to a cantilever. An actuator of a coupling plate usually refers to an actuator coupled to the coupling plate. The coupling may be implemented as described in this document.

Furthermore, the invention relates to a method of operating a micromechanical ultrasonic transducer, which transducer is described in this document, or a method of operating a micromechanical ultrasonic transducer array, which transducer array is described in this document, wherein, in particular at the respective transducer, an electrical control signal is applied to the at least one actuator to generate an ultrasonic wave with the diaphragm or an electrical control signal is output from the at least one actuator to detect an ultrasonic wave with the diaphragm.

The method of operating the ultrasonic transducer or method of operating the ultrasonic transducer array can be designed analogously to the features and effects described in the context of an ultrasonic transducer or ultrasonic transducer array, in particular above, in this document. The same applies analogously to the ultrasonic transducer and/or ultrasonic transducer array with respect to the method of operating the ultrasonic transducer or method of operating the ultrasonic transducer array.

This, and in particular the following, may apply to the transducer in the context of the method of operating the transducer and/or may apply to one or more transducers of the transducer array in the context of the method of operating the transducer array for the respective transducer. Especially, this and in particular the following may apply to the respective transducer of the transducer array.

The actuators of different cantilevers, particularly of the respective transducer, can be operated with different or the same electrical control signals. The actuators of the cantilevers and the at least one actuator of the coupling plate are usually operated with different electrical control signals. The coupling plate may be coupled to or have a plurality of actuators. The actuators of the coupling plate may be operated with mutually different or the same electrical control signals. Operating the actuators with mutually different control signals can be outputting mutually different electrical control signals by the actuators or applying, particularly in a controlled and/or regulated manner, mutually different electrical control signals to the actuators. The actuators can be operated simultaneously. The control signals can differ in phase from one another. If at least one actuator of a cantilever and the actuator of the coupling plate are controlled, a high output sensitivity can be achieved, especially in a piston-shaped vibration mode with respect to a velocity distribution, usually at a first resonance frequency of the diaphragm. Preferably, the actuators, in particular at least one actuator of a cantilever and/or the actuator of the coupling plate, are controlled such that the diaphragm forms a piston-like vibration mode, particularly at a first resonance frequency of the diaphragm. The piston-like form of the vibration mode may refer to a velocity distribution along the diaphragm. The electrical control signal can be transmitted, in particular as described in this document, between an electronic control unit, in particular of the transducer, and the actuators, usually via electrical control lines. An actuator of a cantilever usually refers to an actuator which is coupled to or part of a cantilever. An actuator of a coupling plate usually refers to an actuator which is coupled to or part of the coupling plate. The coupling may be implemented as described in this document. This applies especially to the respective transducer.

Actuators coupled to different cantilevers can be driven with electrical control signals that have substantially the same phase. This can apply to actuators from all cantilevers. Thus, formation of a piston-like vibration mode with respect to a velocity distribution, usually at a first resonant frequency of the diaphragm, can be efficiently supported. This applies especially to the respective transducer.

It has been shown that with driving of one or more actuators of the cantilevers and of the at least one actuator of the coupling plate, a tilt deflection of the coupling plate can be controlled, particularly regulated, efficiently. This can be implemented in a particularly practical manner if the cantilevers and the coupling plate are connected by spring elements, particularly as described in this document. The tilt deflection may relate to one or more rotation axes of the coupling plate. The rotation axes may be oriented parallel to the coupling plate. The rotation axes may be determined by connection points of the coupling plate, at which connection points the cantilevers are connected to the coupling plate, in particularly by the spring elements. This applies especially to the respective transducer.

It is practical if a tilt deflection of the coupling plate is adjusted, particularly controlled, with controlling the actuators. The tilt deflection can be controlled with corresponding control of the actuators, in particular with application of corresponding control signals to the actuators. In particular, this allows to adjust, especially control, an emission direction or detection direction for emission or detection of ultrasonic waves with the diaphragm. Typically, the tilt deflection can be efficiently adjusted with, usually controlling, a second vibration mode and/or third vibration mode of the diaphragm. The third vibration mode usually corresponds to a bending vibration of the coupling plate. The third vibration mode usually contributes to the acoustic output of the diaphragm. In particular, the tilt deflection of the coupling plate can be resonantly controlled in this way. To control the tilt deflection of the coupling plate, at least one actuator coupled to a cantilever and/or at least one actuator coupled to the coupling plate is usually driven, particularly with a respective control signal. The tilt deflection of the coupling plate may be a tilt motion, in particular a tilt oscillation, of the coupling plate. It is practical if periodic electrical control signals are applied to actuators coupled to the cantilevers, wherein electrical control signals of actuators of different cantilevers have a phase difference. Thus, a tilt deflection of the coupling plate can be controlled, especially regulated, in a practicable manner. In particular, the tilt deflection can be controlled, especially regulated, quasi-statically in this way. This applies especially to the respective transducer.

For adjusting the tilt deflection about a respective rotation axis of the coupling plate, the electrical control signals usually correspond to a resonance frequency of a rotational movement of the coupling plate about the rotation axis. The frequency of the electrical control signals is usually selected in a near range around the respective resonance frequency. The resonant frequency may be the resonant frequency of the second vibration mode. Actuators coupled to the cantilevers and the actuator coupled to the coupling plate can be operated with electrical control signals having a phase difference between the electrical control signals of 0° to 180°, particularly a phase difference greater than 0° and smaller than 180°, preferably a phase difference greater than 5° and smaller than 175°.This applies especially to the respective transducer.

It is known from the prior art to achieve an emission of ultrasonic waves in a certain emission direction such that, in an arrangement of a plurality of ultrasonic transducers, the ultrasonic transducers emit ultrasonic waves with a time delay in order to achieve a preferred direction of a propagation of a wave front of the emitted ultrasonic waves by means of generating interference of the ultrasonic waves. An ultrasonic transducer described in this document can be formed such that a controlled tiltability of the coupling plate is achievable. In this way, in an arrangement of a plurality of ultrasonic transducers with controlled tilt deflection of the coupling plates of the ultrasonic transducers, an emission direction of ultrasonic waves, in particular an ultrasonic wave front, can be adjusted.

A method of operating an arrangement of a plurality of micromechanical transducers, particularly transducers as described in this document and/or especially with operating the transducers as described in this document, can be provided, wherein for controlling an emission direction of an ultrasonic wave emitted with the diaphragms of the transducers, the coupling plates of the diaphragms are tilted in the emission direction in a controlled manner. The controlled tilting may be performed with driving actuators of the cantilevers and/or the actuator of the coupling plates. Usually, the transducers are operated with phase-shifted control signals depending on a relative position of the transducers to each other and the lateral emission direction. In this way, ultrasonic waves can be emitted with high efficiency in a specific emission direction. The emission direction can be specified in a controlled manner. The coupling plates can be tilted in the emission direction with control of the actuators. The respective transducer of the arrangement of transducers may be designed and/or operated as described in this document. The arrangement may be an ultrasonic transducer array, particularly as described in this document. The transducers of the arrangement of transducers may be ultrasonic transducer as described in this document with corresponding features and/or effects. The transducers can be operated as described in this document, especially according to the method of operating a transducer.

A method of manufacturing a micromechanical ultrasonic transducer may be provided, wherein with arranging several layers, in particular thin layers, on each other a micromechanical ultrasonic transducer as described in this document is formed. The ultrasonic transducer may be an ultrasonic transducer as described in this document with corresponding features and/or effects. The arrangement of the layers may be performed using a semiconductor process. The method of manufacturing a micromechanical ultrasound transducer may be analogous to the features and effects described in the context of an ultrasound transducer and/or ultrasound transducer array and/or method of operating an ultrasound transducer, particularly above, in this document. The same applies analogously to the ultrasonic transducer, the ultrasonic transducer array and/or the method of operating an ultrasonic transducer with regard to the method of manufacturing the ultrasonic transducer.

Typically, a substrate is provided for forming the base body, and a structural layer is disposed on the substrate for forming the diaphragm. An electrically insulating insulation layer may be disposed between the substrate and the structural layer as part of the base body. The substrate, the structural layer and particularly the insulation layer disposed between them may be provided to the method as starting arrangement. The starting arrangement can be implemented as wafer. An actuator layer arrangement for forming an actuator may be disposed on the structural layer, for example, a first conduction layer, an actuation layer, and typically a second conduction layer. A compensation oxide layer (CPS) may be disposed between the actuator layer arrangement and the structural layer. Typically, a plurality of actuator layer arrangements are arranged to form the respective actuators. An electrically insulating separation layer may be disposed on the actuation layer, typically between the actuation layer and the second conduction layer. A protective layer may be disposed on the actuator layer arrangement. The protective layer may be configured to protect the actuator from an ambient atmosphere. The protective layer may extend along substantially an entire underlying layer arrangement for forming the diaphragm and/or along substantially an entire respective actuator arrangement. Typically, the layers are arranged such that segments of the first conduction layer and/or segments of the second conduction layer are exposed such that the segments are electrically contactable to apply electrical control signals to the conduction layers, particularly to an actuator formed with the conducting layers. The actuation layer is usually a layer of the actuator that can be manipulated, in particular moved and/or elastically deformed, by driving the actuator. The actuation layer can be a piezoelectric layer. The first conduction layer and second conduction layer can form electrodes of the actuator.

The, particularly aforementioned, layers are respectively implemented forming a structured pattern. In particular, the layers, especially the structural layer, can be implemented with a structured pattern such that the pattern corresponds to slits of the diaphragm. Alternatively or cumulatively, slits of the diaphragm may be formed by removing material of the layers forming the diaphragm. The slits are typically formed such that the diaphragm comprises a plurality of cantilevers, the coupling plate and, in particular, the spring elements.

In the transducer structure formed with the substrate and the layers, the cavity is usually formed below the diaphragm, in particular below the structural layer, adjacent to the diaphragm, in particular the structural layer. The cavity may be formed by removing material from the substrate and/or the insulating layer. The removal may be accomplished with an etching process. In particular, the cavity may extend, typically in the arrangement direction, from a side of the substrate opposite the structural layer to the structural layer. Usually, with insertion of the cavity, the diaphragm is formed as a component individualized from the base body, which is arranged above the cavity, in particular capable of vibrating.

Weight elements can be formed on a back side of the diaphragm by selectively removing material during cavity insertion with removal of material, so that weight elements are formed on a side of the structural layer facing the cavity. The weight elements may be implemented with material of the substrate and/or the insulation layer. Weight elements may be formed on a front side of the diaphragm by disposing material to form the weight elements over, particularly on, the second conduction layer, typically between the second conduction layer and the protective layer. The weight elements are typically formed with, particularly from, an electrically insulating material.

The back side of the diaphragm usually denotes a side of the diaphragm facing the substrate and/or the cavity. The front side of the diaphragm usually denotes a side of the diaphragm facing away from the substrate and/or the cavity, which is usually opposite to the back side. The substrate and the layers are usually arranged on each other in an arrangement direction orthogonal to an extension direction and/or arrangement surface of the diaphragm to be formed. The substrate is usually a substrate layer. The substrate and the layers are usually applied to each other.

The substrate, the structure layer and, if present, the insulation layer may be formed by a wafer. The wafer can be a silicon wafer, a silicon on insulator (SOI) wafer, a polysilicon on insulator (POI) wafer, an epitaxial silicon on insulator wafer, or a germanium on insulator (GOI) wafer. The structural layer can be formed with a thickness ranging from 10 nm to 100 µm, typically from 1 µm to 50 µm, for example 5 µm. The substrate, in particular the substrate layer, can be formed with a thickness ranging from 50 nm to 1 mm, particularly from 5 µm to 500 µm, for example 350 µm. The first conduction layer and second conduction layer and/or the electrodes of the respective actuator can be formed with, particularly from, an electrically conductive material, in particular a metal, for example platinum or molybdenum. In particular, the first conduction layer or one of the electrodes of the actuator may be formed with, particularly from, platinum. The second conduction layer or the other electrode of the actuator may be formed with, particularly from, molybdenum. The insulation layer may be an electrically insulating oxide layer.

The micromechanical ultrasonic transducer is typically a piezoelectric micromechanical ultrasonic transducer. A plurality, particularly all, of the cantilevers may be implemented in an analogous manner or same manner. Statements in this document regarding one cantilever, in particular its features, can apply accordingly to at least one, particularly several, preferably all, of the cantilevers, in particular their features, in an analogous manner.

The invention will now be described by way of example with reference to the accompanying drawings, in which:
Fig. 1 to Fig. 4 show different variants of a micromechanical ultrasonic transducer in top view;
Fig. 5 shows a further micromechanical ultrasonic transducer in top view;
Fig. 6 shows the micromechanical ultrasonic transducer of Fig. 5 in a perspective view;
Fig. 7 shows the ultrasonic transducer of Fig. 5 in a cross-sectional view;
Fig. 8 shows another representation of the ultrasonic transducer of Fig. 5 in top view;
Fig. 9 shows an illustration of the ultrasonic transducer of Fig. 5 in different cross-sections;
Fig. 10 shows a microscopic image of the diaphragm of the ultrasonic transducer of Fig. 5;
Fig. 11a and Fig. 11b show a comparison of a frequency response of a central velocity of the ultrasonic transducer of Fig. 5, depicted in Fig. 11a, and a conventional ultrasonic transducer, depicted in Fig. 11b, and a spatial representation of associated vibration modes;
Fig. 12 shows the diaphragm of the ultrasonic transducer of Fig. 1 to Fig. 4 in a state of controlled tilt deflection of a respective coupling plate;
Fig. 13 and Fig. 14 show illustrations of a control of an emission angle of an emission of ultrasonic waves with a micromechanical ultrasonic transducer array with controlled tilt deflection of the coupling plates compared to a control based on interference of the ultrasonic waves;
Fig. 15a and Fig. 15b show a pressure output of a micromechanical ultrasonic transducer array with controlled tilt deflection of the coupling plates, depicted in Fig. 15a, compared to a control based on interference, depicted in Fig. 15b;
Fig. 16 shows an illustration of three vibration modes of a diaphragm of the ultrasonic transducer of Fig. 5;
Fig. 17 and Fig. 18 show schematic illustrations of a transducer in a cross-section, wherein the coupling plate comprises a weight element on its rear side or front side;
Fig. 19 shows a schematic illustration of a diaphragm in top view, wherein the coupling plate comprises weight elements in a circumferential direction of the coupling plate;
Fig. 20 to Fig. 29 show a schematic illustration of a manufacturing method of a micromechanical ultrasonic transducer;
Fig. 30 shows a top view schematic diagram of an ultrasonic transducer array 12.

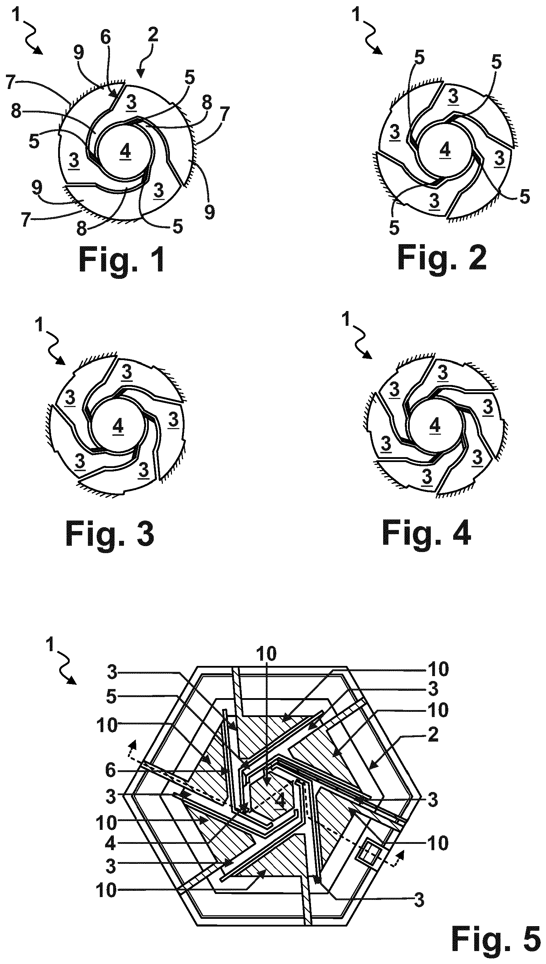

Fig. 1 to Fig. 4 show schematic representations of different variants of a micromechanical ultrasonic transducer 1 in top view. The respective ultrasonic transducer 1 has a flexible diaphragm 2 for emission or detection of ultrasound, the diaphragm 2 comprising a coupling plate 4 and a plurality of cantilevers 3 arranged around the coupling plate 4, wherein the cantilevers 3 are connected to the coupling plate 4 via spring elements 5. The diaphragm 2 is connected to a rigid base body. In top view of the diaphragm 2, the cantilevers 3 are arranged side by side along a circumference about the coupling plate 4. The cantilevers 3 and the coupling plate 4 are separated from each other by slits 6. Due to a boundary releasing structure realized by this cantilever-coupling plate 4 coupled structure, the geometric nonlinearity of the ultrasonic transducer 1 can be largely reduced. Particularly, the ultrasonic transducer 1 can achieve higher output capacity within its linear working condition. The coupling plate 4 is usually located in a center region of the diaphragm 2 in top view. For ease of reading, micromechanical ultrasonic transducer 1 is abbreviated as ultrasonic transducer 1 and/or as transducer 1 and micromechanical ultrasonic transducer array is abbreviated as ultrasonic transducer array and/or transducer array.

The cantilevers 3 and the coupling plate 4 each include an actuator for correspondingly transitioning with the actuator between a vibration of the respective cantilever 3 or the coupling plate 4 and an electrical control signal, typically in the form of an AC electrical voltage. The actuators 10 are preferably piezoelectric actuators 10. A first end 8 of the respective cantilever 3 is connected to an anchor structure 7, and a second end 9 of the cantilever 3 is connected to the coupling plate 4 by a spring element 5. The respective cantilever 3 is typically tapered in an extension direction from the first end 8 to the second end 9. The respective cantilever 3 may have an arcuate shape in top view, in particular a shape of a spiral segment. The cantilevers 3 may be arranged in a form of interlaced nested spirals. It is advantageous if the cantilevers 3 have an identical shape and/or an identical size. The cantilevers 3 can form a tightly-packed arrangement. It is provided that along a circumference around the coupling plate 4, respectively adjacent cantilevers 3 overlap each other in sections in the radial direction of the coupling plate 4.

Preferably, the spring elements 5 are connected to the coupling plate 4 at regular distances from each other along a circumference around the coupling plate 4 in top view. The cantilevers 3 usually can be excited with the actuators 10 by a reversed piezoelectric effect, such that the coupling plate 4 is driven to form a piston-like vibration mode. The design of the diaphragm 2 is not limited to any specific number of the driving cantilever 3 or spring elements 5. Exemplary variants of a diaphragm 2 with such cantilevers 3 are shown in Fig. 1 to Fig. 4, wherein Fig. 1 shows a variant with three cantilevers 3, Fig. 2 shows a variant with four cantilevers 3, Fig. 3 shows a variant with five cantilevers 3, and Fig. 4 shows a variant with six cantilevers 3. The diaphragm 2 and the coupling plate 4 can have a corner-free, particularly circular, shape. Top view usually refers to a top view of the diaphragm 2, particularly orthogonal to an arrangement plane representing an areal extension of the diaphragm 2.

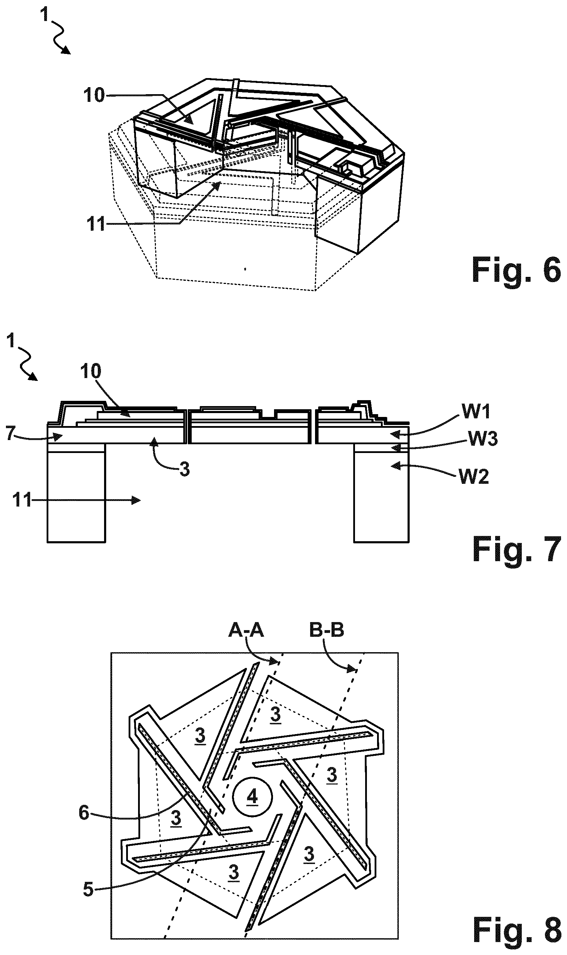

Fig. 5 shows a schematic illustration of a further micromechanical ultrasonic transducer 1 in top view. The transducer 1 can be designed as explained above for Fig. 1 to Fig. 4. The diaphragm 2 of the transducer 1 is exemplarily implemented with six cantilevers 3. In contrast to the illustration of Fig. 1 to Fig. 4, the cantilevers 3 have an essentially triangular shape in top view. The diaphragm 2 and/or the coupling plate 4 have an exemplary hexagonal shape in top view. Fig. 6 shows a schematic illustration of the transducer 1 of Fig. 5 in a perspective view. The diaphragm 2, particularly the first ends 8 of the cantilever 3, are fixed to an anchor structure 7, wherein the anchor structure 7 is formed with a base body of the transducer 1. The diaphragm 2 is arranged over a cavity 11 of the transducer 1. Fig. 7 shows a schematic illustration of the transducer 1 of Fig. 5 in a cross section. Ultrasonic waves can be generated by vibrating the diaphragm 2, in particular the cantilevers 3 and the coupling plate 4, with the actuators 10. The anchor structure 7 can be connected to an outer edge of the diaphragm 2, which defines the boundary of the diaphragm 2. The anchor structure 7 can represent an immobile point the cantilever 3 is connected to. The actuators 10 can receive an electrical control signal to actuate the diaphragm 2. Usually, the electrical control signal and the resulting sound wave produced by the ultrasound transducer 1 correspond to each other. The ultrasonic transducer 1 can operate within a working frequency range of 40 kHz to 1 MHz, particularly when in an air coupled working condition.

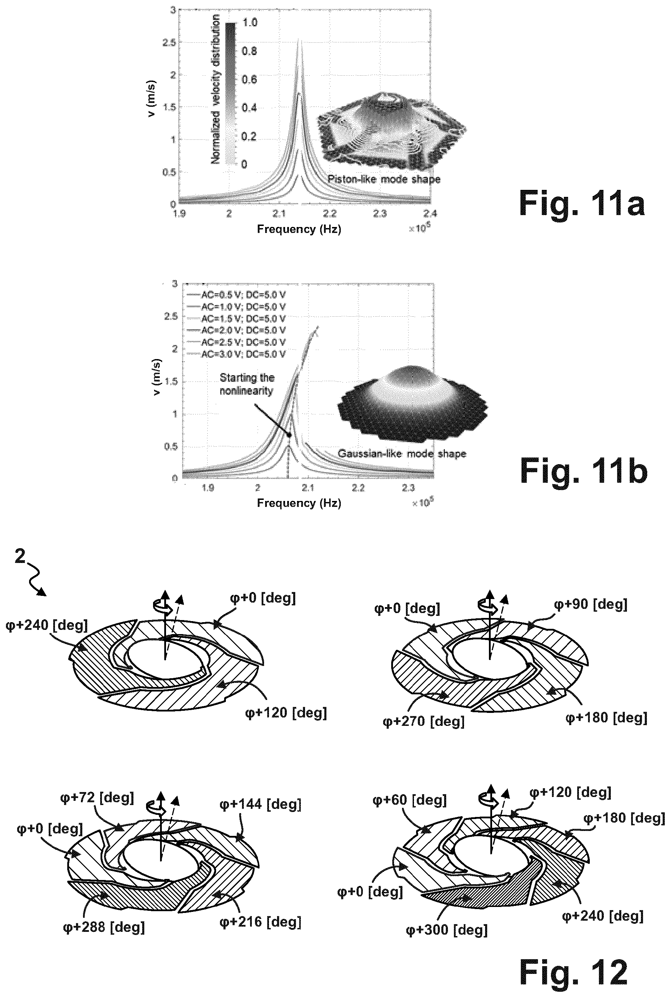

Usually, the first resonance frequency of the diaphragm 2 is the diaphragm's lowest resonance frequency. Due to the described design of the diaphragm 2 with cantilevers 3, which are connected to the coupling plate 4 via spring elements 5, the diaphragm 2 can vibrate in a strongly pronounced piston-like mode shape during its first resonant frequency. This is depicted in Fig. 11a. Particularly, by applying an electrical control signal with the same phase to each of the actuators 10 coupled to the cantilevers 3 this vibration mode shape can be realized. The output sensitivity of this vibration mode shape can be further increased by exciting the actuator coupled to the coupling plate 4. Depending on an area occupation ratio between an area of the coupling plate 4 and an area of the entire diaphragm 2, a relative phase difference between the excitation signals used to drive the actuators 10 coupled to the coupling plate 4 and the actuator coupled cantilever 3 can range from 0° to 180°. This applies particularly in top view. Although the ultrasonic transducer 1 of Fig. 1 to Fig. 7 are used as an example for explanation, the present invention is usually not limited to this type.

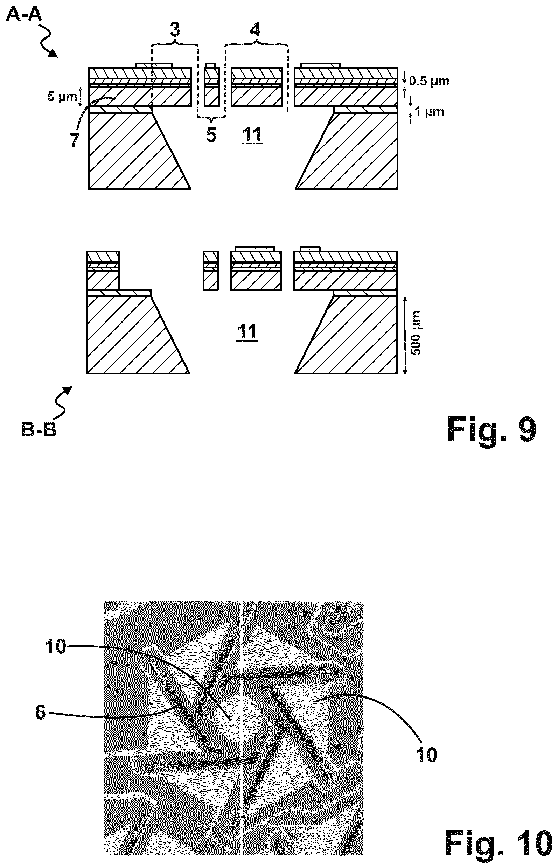

Fig. 8 shows another schematic illustration of the micromechanical ultrasonic transducer 1 of Fig. 5 in top view. The slits 6 are shown by white lines. A cavity 11 edge of the cavity 11 adjacent to the diaphragm 2 is shown with dashed white lines. Fig. 9 shows a schematic illustration of the transducer 1 of Fig.5 in two cross sections A-A and B-B. The cross sections are drawn as black, dashed lines in Fig. 8. Fig. 10 shows a microscopic image of the diaphragm 2 of the micromechanical transducer 1 of Fig. 5. The slits 6 are shown as black lines. The actuators 10 and electrical control lines are shown as light areas and light lines. The actuators 10 of the cantilevers 3 and the actuator of the coupling plate 4 respectively have their own electrical control lines to control the actuators 10 of the cantilevers 3 and the actuator of the coupling plate 4 with different electrical control signals.

Fig. 11a and Fig. 11b show an illustration of a comparison of a frequency response of a central velocity of the transducer 1 of Fig. 5 and a conventional micromechanical ultrasonic transducer in the form of two graphs, as well as a spatial representation of associated vibration modes. Fig. 11a corresponds to the transducer 1 of Fig. 5, and Fig. 11b corresponds to a conventional ultrasonic transducer formed with a full-area circular diaphragm 2. The mechanical characterization results shown in Fig. 11a and Fig.11b indicate that with a similar resonant frequency and central velocity, the piston-like vibration mode enabled the transducer 1 of Fig. 5 to achieve a larger volumetric vibration velocity of at least 80 % more than the conventional transducer, which indicates much higher output sensitivity. Furthermore, the linear working range of the transducer 1 of Fig. 5 was remarkably extended by more than 183 %, which indicates the transducer 1 of Fig. 5 can achieve much higher output capacity within the linear working range, compared to the conventional transducer.

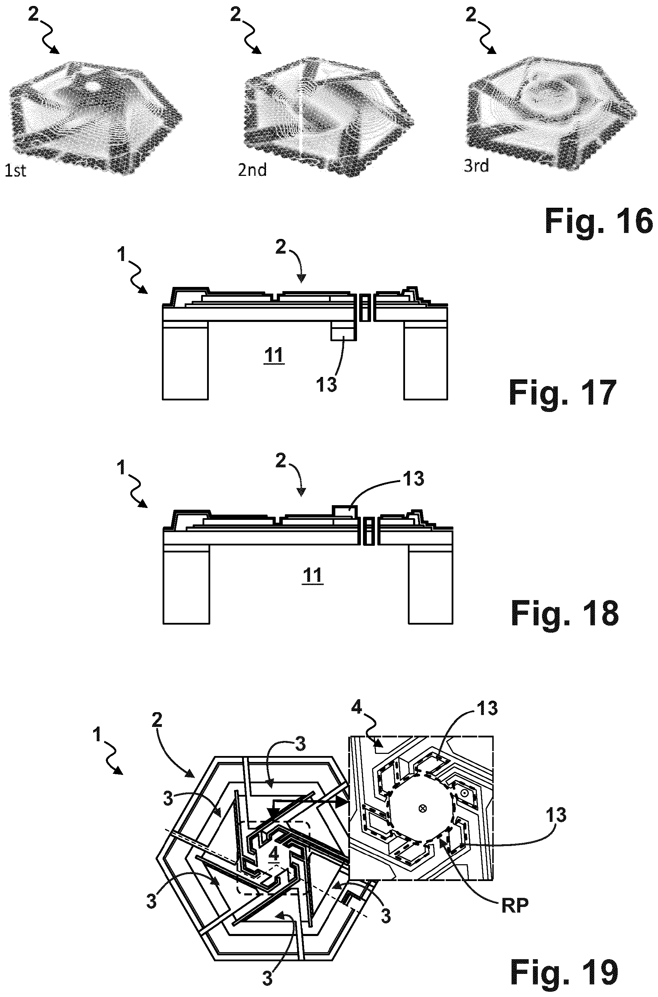

With driving of one or more actuators 10 coupled to the cantilevers 3 and/or of the at least one actuator coupled to the coupling plate 4, a tilt deflection of the coupling plate 4 can be controlled, particularly regulated. Thus, an ultrasonic beam steering can be implemented. The acoustic beam steering working condition is usually based on the second and third symmetric vibration modes of the diaphragm 2, as indicated in Fig. 16. Fig. 16 shows an illustration of three vibration modes of a diaphragm 2 of the transducer 1 of Fig. 5, achieved by a laser vibrometer. The second vibration mode of the diaphragm 2 can be utilized to tilt and/or steer the coupling plate 4, with high practicability. When combined with the bending vibration mode of the coupling plate 4, which contributes to the acoustic output and is represented by the third vibration mode, the acoustic beam can be mechanically steered in a resonant mode. Moreover, the beam steering can be achieved in a quasi-static mode by adjusting the electrical control signal applied to the actuators 10 coupled to the cantilevers 3.

Fig. 12 shows a schematic representation of the diaphragm 2 of the transducers 1 of Fig. 1 to Fig. 4 in a state of controlled tilt deflection of a respective coupling plate 4. By applying periodic electrical control signals to one or more actuators 10 coupled to the cantilevers 3 a tilt motion of the coupling plate 4 can be stimulated. The electrical control signals may correspond to each of the two or three axes of the tilt motion of the coupling plate 4 and possess a frequency that matches or closely aligns with the resonance frequency, particularly the resonance frequency of the second vibration mode, linked to the respective axis. By utilizing equal or nearly equal frequencies in the electrical control signal, a high scanning path fill factor can be achieved, which can support a wide ultrasonic beam steering angle, particularly emission angle. The electrical control signals can be applied to actuators, such that electrical control signals of actuators of different cantilevers have a phase difference φ, particularly as depicted in Fig. 12.

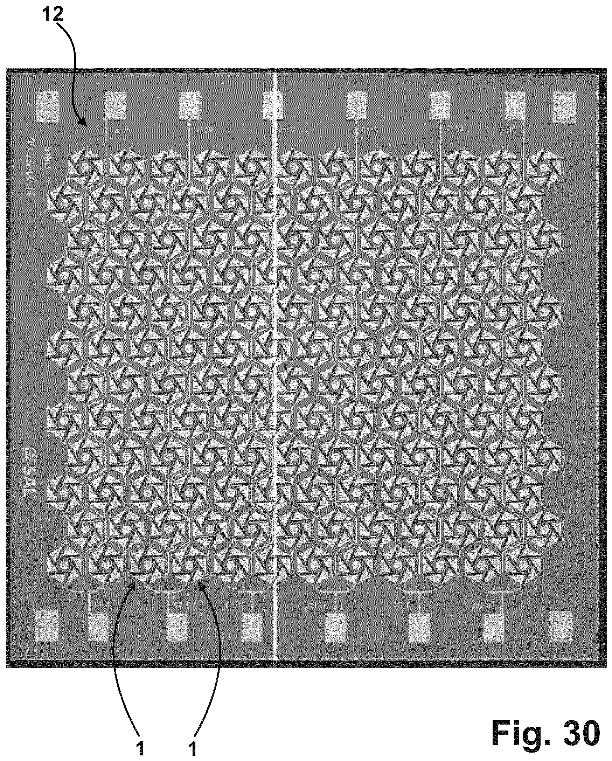

A micromechanical ultrasonic transducer array 12 comprising a plurality of ultrasonic transducers 1, particularly ultrasonic transducers 1 such as described in Fig. 5, may be provided. The transducer array 12 comprises multiple diaphragms 2, which can be manufactured simultaneously on a common substrate, or alternatively, multiple transducers 1 can be disposed on a common substrate individually. Fig. 30 illustrates a top view schematic diagram of a corresponding ultrasonic transducer array 12. Each transducer 1 can function as a unit that produces ultrasonic waves. Essentially in this way, the transducer array 12 can include multiple ultrasound producing units, and each ultrasound producing unit can be realized through a transducer 1, especially the transducer 1 of Fig. 5. The ultrasonic transducer array 12 is usually part of a PMUT chip.

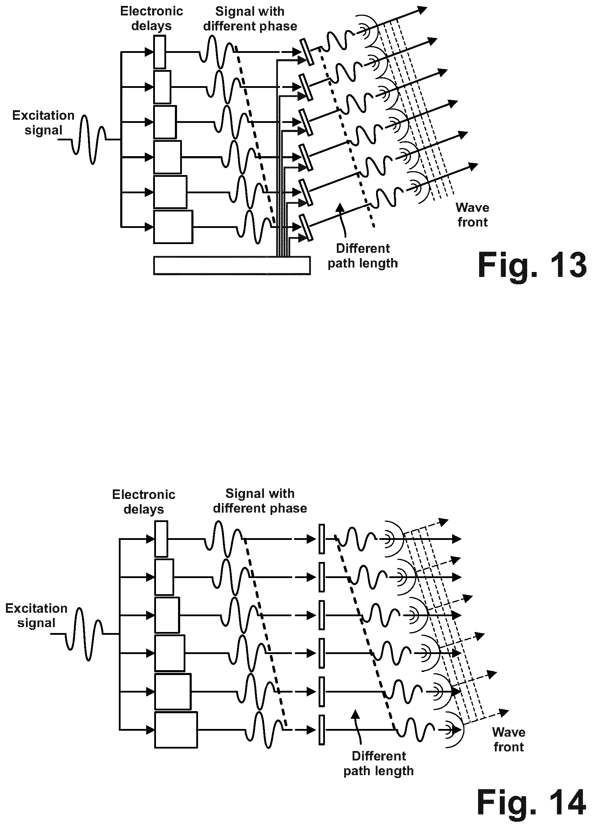

Fig. 13 and Fig. 14 show schematic illustrations of a control of an emission angle for an emission of ultrasonic waves with the transducer array 12, where Fig. 13 shows a control of the emission angle with a controlled tilt deflection of the coupling plates 4, and Fig. 14 shows a control of the emission angle based on an interference of emitted ultrasonic waves. Fig. 13 corresponds to an ultrasonic beam steering of an ultrasonic array 12 of transducers 1 according to Fig. 5. Fig. 14 corresponds to an ultrasonic beam steering of an ultrasonic transducer array 12 of conventional ultrasonic transducers. Fig. 13 and Fig. 14 show the schematic of an ultrasonic beam steering working condition achieved by 1D transducer arrays 12, respectively. The ultrasonic beam steering mechanism of a transducer array of conventional transducers is usually limited to steering the ultrasonic beam through electrical signal delay using a phased array. In contrast, the ultrasonic transducer array 12 of ultrasonic transducers 1 according to Fig. 5 utilizes a phased array 12 signal to drive the actuator of the coupling plate 4 for acoustic transmission. Then, corresponding excitation signals are applied to the actuators 10 of each cantilever 3 of each transducer 1 based on their position in the transducer array 12, to turn the coupling plate 4 towards the desired direction, thereby enhancing the output power of the steerable ultrasonic beam. Compared to the conventional transducer array that only uses the phased array method for beam steering, the transducer array 12 combining the phased array and mechanical steering method by tilting the coupling plates 4 can effectively suppress acoustic sidelobes.

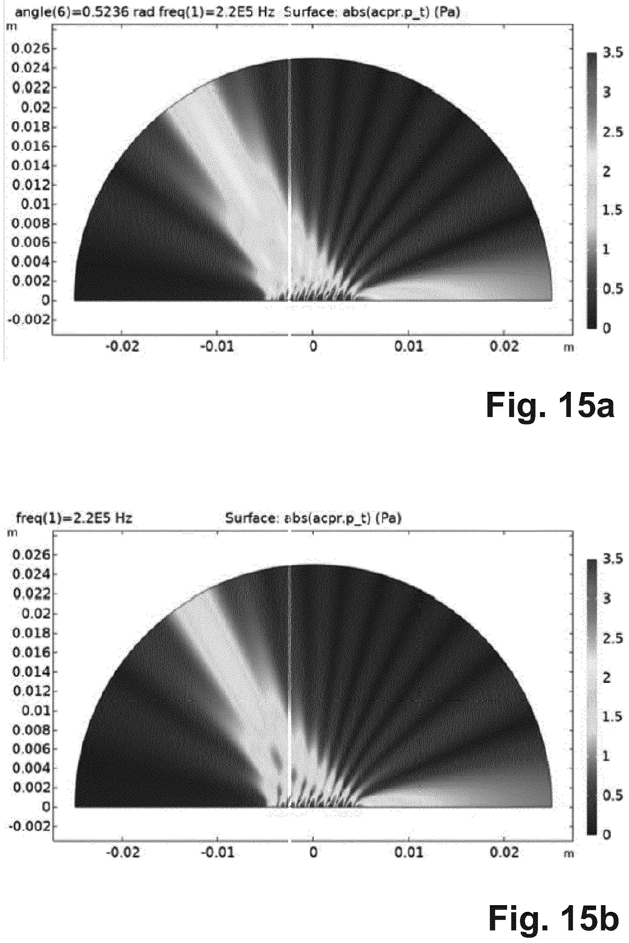

In Fig. 15a and Fig. 15b, the output pressure generated by the transducer array 12 with transducers 1 according to Fig. 5 and by the transducer array with conventional transducers is shown when excited by the same voltage amplitude. Fig. 15a represents a pressure output of a transducer array 12 with transducers 1 according to Fig. 5 and with controlled tilt deflection of the coupling plates 4 of the transducers 1. Fig. 15b represents a pressure output of a transducer array with conventional ultrasonic transducers with an emission direction set based on interference of the emitted ultrasonic waves. It can be observed that the transducer array 12 with transducers 1 according to Fig. 5 achieves a 30% increase in maximum output pressure with a 30-degree steering angle, particularly emission angle, compared to the transducer array with conventional transducers. The beam steering system can operate beyond just 1D steering, as it is capable of achieving higher energy utilization efficiency and better spatial resolution when utilized for 2D steering or focusing. In particular, the transducers 1 of the transducer array 12 may be arranged annularly or in multiple rows, wherein each transducer 1 operates dynamically to steer the ultrasound, and particularly create a circular scanning pattern for ultrasonic focusing.

Typically, the mechanical steering of the acoustic beam is achieved by the coupling plate's vibration superimposed on the driving cantilevers' steering. To enhance the device's operational stability, an inertia moment-balanced design is beneficial. Extra weight in form of weight elements 13 can be arranged on the coupling plate 4, particularly such that in use, upon vibration excitation of the coupling plate 4, an inner region of the coupling plate 4 with respect to a radial direction of the coupling plate 4 and an outer region of the coupling plate 4 pivot, particularly vibrate, in opposite directions, illustrated in Fig. 19. Fig. 19 shows a schematic illustration of a diaphragm 2 in top view, wherein the coupling plate 4 additionally comprises weight elements 13, particularly regularly distributed, in a circumferential direction of the coupling plate 4. The coupling plate 4 is divided into two regions by a rotating pivot RP. This vibration mode ensures that the coupling plate 4 is excited in a dynamically balanced manner, minimizing net momentum change that could cause a reaction force through the spring elements 5 to the cantilever 3. Balancing these reaction forces supports the device's operational stability and ensures low energy loss from the coupling plate 4 to the cantilever 3. Weight elements 13 may be arranged on a front side and/or rear side of the coupling plate 4. Fig. 17 shows a schematic illustration of a transducer 1 in a cross-section, wherein the coupling plate 4 comprises a weight element 13 on its rear side. Fig. 18 shows a schematic representation of a transducer 1 in a cross-section, wherein the coupling plate 4 comprises a weight element 13 at its front side. The transducer 1 may be made of various high stiffness materials, for example silicon, such as single crystalline or poly-crystalline silicon, silicon carbide, germanium, gallium nitride, gallium arsenide, stainless steel, or a combination thereof. The transducer 1 may be fabricated from different types of wafers WF such as a silicon wafer WF, a silicon on insulator wafer WF, a polysilicon on insulator wafer WF, an epitaxial silicon on insulator wafer WF, or a germanium on insulator wafer WF.

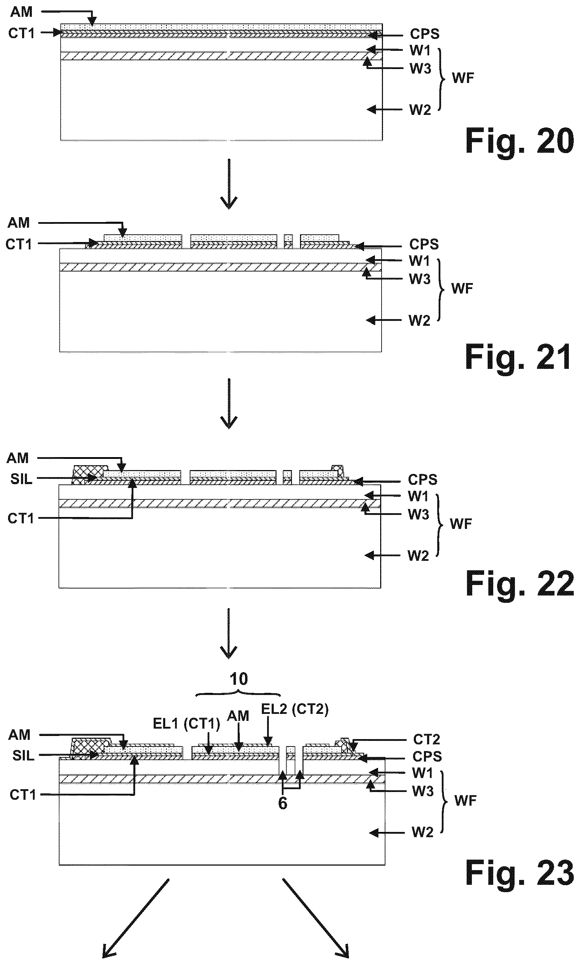

Fig. 20 to Fig. 29 schematically show a method of manufacturing a micromechanical ultrasonic transducer 1. A wafer WF can be provided to the process, wherein the wafer WF comprises a structural layer W1, an electrical insulating insulation layer W3, and a substrate layer W2. For example, the structural layer W1 and the substrate layer W2 may consist of single crystalline silicon, poly-crystalline silicon, silicon carbide, germanium, gallium nitride, gallium arsenide, stainless steel, or any other high stiffness material or combination thereof. The thicknesses of the structural layer W1, the insulation layer W3 and the substrate layer W2 may be individually adjusted based on requirements. For example, the thickness of the structural can be 5 µm, and the thickness of the substrate layer W2 can be 350 µm, but not limited thereto. In Fig. 20, it is optional to form a compensation oxide layer CPS on one side of the wafer WF. On the top side of the wafer WF, a first conduction layer CT1 and an actuation material AM can be formed in sequence. The first conduction layer CT1 and the actuation material AM can be made of any suitable conductive and piezoelectric materials, respectively. In some instances, the first conduction layer CT1 may consist of metal, like platinum, while the actuation material AM may consist of a piezoelectric material, such as lead-zirconate-titanate, PZT.

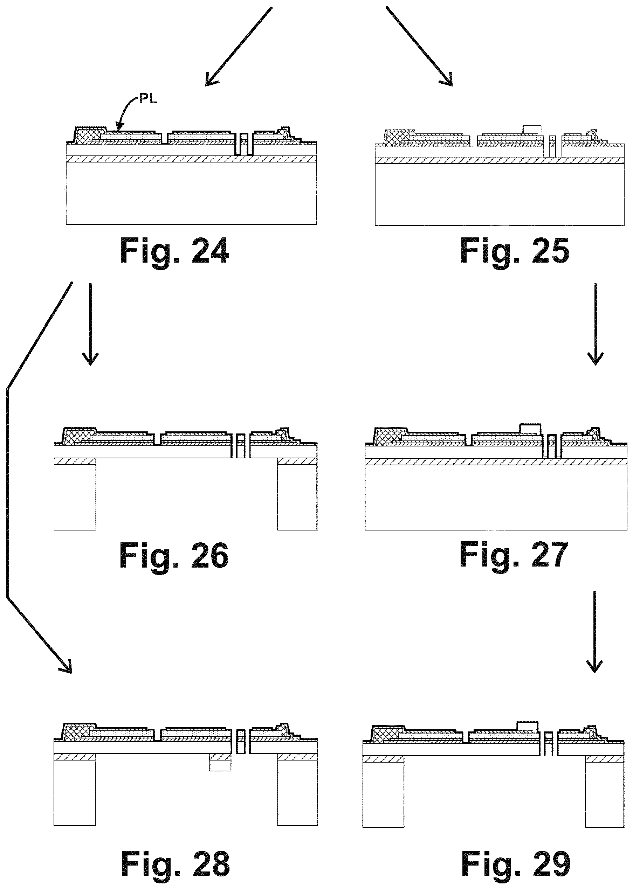

Fig 21 illustrates a patterning of the actuation material AM, first conduction layer CT1, and the compensation oxide layer CPS. In some cases, these layers may be patterned in a sequential manner. In Fig. 22, an electrical insulating separating insulating layer SIL, also denoted as separation layer, is formed on the actuation material AM and patterned. In some embodiments, oxide may be used as the material for the separating insulating layer SIL, although other materials may also be suitable. In Fig. 23, a second conduction layer CT2 is formed on top of the actuation material AM and the separating insulating layer SIL, which is then patterned. For example, the second conduction layer CT2 may consist of metal, such as molybdenum, but not limited to that. The first conduction layer CT1 and the second conduction layer CT2, after being patterned, act as the first electrode and the second electrode respectively for the actuator. The actuation material AM, the first electrode and the second electrode form the piezoelectric actuator. The first electrode and the second electrode are usually in contact with the actuation material AM. In Fig. 26, the separating insulating layer SIL is designed to separate a portion of the first conduction layer CT1 from a portion of the second conduction layer CT2. Additionally, the structural layer W1 may be patterned to create a trench line, which refers to the area where the structural layer W1 is removed.

To implement a first implementation of the transducer 1 without weight elements 13 disposed on the coupling plate 4, a protection layer PL may be optionally formed on the second conduction layer CT2, to cover the wafer WF, the first conduction layer CT1, the actuation material AM, the separating insulating layer SIL and the second conduction layer CT2. This is shown in Fig. 24. For the first implementation without the extra weight distribution on the coupling plate 4, a protection layer PL may optionally be formed on the second conduction layer CT2, shown in Fig. 26. The protection layer PL is designed to cover the wafer WF, the first conduction layer CT1, the actuation material AM, the separating insulating layer SIL, and the second conduction layer CT2. In some embodiments, the protection layer PL is intended to shield the actuator from environmental exposure and ensure its reliability and stability. In Fig. 26, it is optional to pattern the protection layer PL to expose a portion of the second conduction layer CT2 and/or a portion of the first conduction layer CT1. This can be done to form a connecting pad that allows for electrical connection to an outer device. The connecting pad can be used to connect the actuator to other electrical circuitry within the device, such as a control circuit or power supply. As shown in Fig 26, the substrate layer W2 can be patterned to form at least one anchor structure 7, while the structural layer W1 forms the diaphragm 2 anchored by the anchor structure 7. Specifically, a first part of the substrate layer W2 is removed, and a second part of the substrate layer W2 forms the anchor structure 7. Due to the removal of the first part of the substrate layer W2, the structural layer W1 forms the diaphragm 2. As a result, the slit 6 is formed within and penetrates through the diaphragm 2 due to the presence of the trench line. The formation of the slit 6 leads to the creation of the respective spring element 5, particularly spring element 5, of the diaphragm 2.

To implement a second implementation of the transducer 1 with a weight element 13 disposed on a rear-side of the coupling plate 4, a protection layer PL is formed on the second conduction layer CT2, shown in Fig. 26. Afterward, an etching step is conducted to form the cavity 11 and to release the diaphragm 2, wherein a weight element 13, particularly multiple weight elements 13, on the rear side of the coupling plate 4 is formed, shown in Fig. 28.

To implement a third implementation of the transducer 1 with a weight element 13 disposed on the front-side of the coupling plate 4, material is deposited on the top electrode to form the weight element 13, particularly multiple weight elements 13, shown in Fig. 27. Then a protection layer PL may be optionally formed on the second conduction layer CT2 and on the weight elements 13 to cover the wafer WF, the first conduction layer CT1, the actuation material AM, the separating insulating layer SIL, and the second conduction layer CT2. To form the cavity 11 and to release the diaphragm 2 an etching step is conducted, shown in Fig. 29.

In this way, if the transducer 1 has a diaphragm 2, wherein the diaphragm 2 comprises a coupling plate 4 and a plurality of cantilevers 3 arranged around the coupling plate 4, wherein the cantilevers 3 are connected to the coupling plate 4 through spring elements 5, and wherein the cantilevers 3 can be excited to vibration by actuators 10 coupled to the cantilevers 3, preferably with reversed piezoelectric effect, with controlling the actuators 10, a vibration of the diaphragm 2 with a piston-like vibration mode can be achieved, thereby increasing output sensitivity of the device. In particular, due to this boundary released structure of the diaphragm 2 a geometric nonlinearity of the transducer 1 can be largely reduced. By this means, a high output capacity within a linear working condition of the transducer 1 can be realized. With controlling a tilt deflection of the coupling plate 4 a high directivity and output sensitivity can be attained.

## Claims

1. Micromechanical ultrasonic transducer (1) for ultrasonic wave generation or ultrasonic wave detection, wherein the ultrasonic transducer (1) comprises a diaphragm (2) and at least one actuator for the emission or detection of ultrasound, wherein the actuator is designed to transfer between an elastic deformation, in particular a vibration, of the diaphragm (2) and an electrical control signal corresponding to each other, wherein the diaphragm (2) comprises a coupling plate (4) and a plurality of cantilevers (3) arranged around the coupling plate (4), wherein the cantilevers (3) are connected to the coupling plate (4), preferably via spring elements (5), so that with elastic deformation of the cantilevers (3) a vibration of the coupling plate (4) can be excited, **characterized in that** along a circumference around the coupling plate (4) respectively adjacent cantilevers (3) overlap each other in sections in radial direction of the coupling plate (4).

2. Micromechanical ultrasonic transducer (1) according to claim 1, wherein the respective cantilever (3) is fixed with a first end (8) of the cantilever (3) to an anchor structure (7) and is connected with a second end (9) of the cantilever (3) via a spring element (5) to the coupling plate (4).

3. Micromechanical ultrasonic transducer (1) according to claim 1 or 2, wherein, in top view of the diaphragm (2), the cantilevers (3) are separated from each other by slits (6).

4. Micromechanical ultrasonic transducer (1) according to any one of claims 1 to 3, wherein the respective cantilever (3) is coupled to one of the actuators, wherein the actuator is designed to transfer between an elastic deformation, in particular vibration, of the cantilever (3) and an electrical control signal corresponding to each other.

5. Micromechanical ultrasonic transducer (1) according to any one of claims 1 to 4, wherein the coupling plate (4) is coupled to one of the actuators, wherein the actuator is designed to transfer between an elastic deformation, in particular vibration, of the coupling plate (4) and an electrical control signal corresponding to each other.

6. Micromechanical ultrasonic transducer (1) according to any one of claims 1 to 5, wherein the respective actuator is formed with a piezoelectric element.

7. Micromechanical ultrasonic transducer (1) according to any one of claims 1 to 6, wherein the diaphragm (2) is arranged upon a cavity (11) of the transducer (1).

8. Micromechanical ultrasonic transducer (1) according to any one of claims 1 to 7, wherein the coupling plate (4) has a varying mass distribution for inertia balancing such that in use, an inner region of the coupling plate (4) with respect to a radial direction of the coupling plate (4) and an outer region of the coupling plate (4) are pivoted in opposite directions.

9. Micromechanical ultrasonic transducer (1) according to any one of claims 1 to 8, wherein the coupling plate (4) has weight elements (13) for inertia balancing on a front side and/or rear side of the coupling plate (4), particularly in an edge region of the coupling plate (4), which weight elements (13) are preferably arranged regularly spaced from one another along an edge direction around the coupling plate (4).

10. Micromechanical ultrasonic transducer array (12), comprising a plurality of micromechanical ultrasonic transducers (1) according to any one of claims 1 to 9, wherein the transducers (1) comprise a common substrate, preferably wherein the diaphragms (2) of the transducers (1) are arranged in rows or in the form of a closed line on the substrate.

11. Method of operating a micromechanical ultrasonic transducer (1) according to any one of claims 1 to 9 or a micromechanical ultrasonic transducer array (12) according to claim 10, wherein at the respective transducer (1) an electrical control signal is applied to the at least one actuator to generate an ultrasonic wave with the diaphragm (2) or an electrical control signal is output from the at least one actuator to detect an ultrasonic wave with the diaphragm (2).

12. Method according to claim 11, wherein a tilt deflection of the coupling plate (4) is adjusted, particularly controlled, with controlling the actuators (10), in particular with driving one of the actuators coupled to a cantilever (3) and driving one of the actuators coupled to the coupling plate (4).

13. Method according to claim 11 or 12, wherein periodic electrical control signals are applied to the actuators (10) coupled to the cantilevers (3), wherein electrical control signals of actuators (10) of different cantilevers (3) have a phase difference.

14. Method of manufacturing a micromechanical ultrasonic transducer (1), wherein with arranging several layers, in particular thin layers, on each other, wherein the layers are implemented forming a structured pattern, a micromechanical ultrasonic transducer (1) according to any one of claims 1 to 9 is formed.

## Patentansprüche

1. Mikromechanischer Ultraschallwandler (1) zur Ultraschallwellenerzeugung oder Ultraschallwellenerfassung, wobei der Ultraschallwandler (1) eine Membran (2) und mindestens einen Aktor für die Emission oder Erfassung von Ultraschall umfasst, wobei der Aktor dafür gestaltet ist, zwischen einer elastischen Verformung, insbesondere einer Vibration, der Membran (2) und einem elektrischen Signal, die einander entsprechen, zu übertragen, wobei die Membran (2) eine Kopplungsplatte (4) und eine Vielzahl von Auslegern (3), die um die Kopplungsplatte (4) angeordnet sind, umfasst, wobei die Ausleger (3), vorzugsweise über Federelemente (5), mit der Kopplungsplatte (4) verbunden sind, so dass mit einer elastischen Verformung der Ausleger (3) eine Vibration der Kopplungsplatte (4) angeregt werden kann, **dadurch gekennzeichnet, dass** entlang eines Umfangs um die Kopplungsplatte (4) jeweils benachbarte Ausleger (3) einander in Schnitten in einer Radialrichtung der Kopplungsplatte (4) überlappen.

2. Mikromechanischer Ultraschallwandler (1) nach Anspruch 1, wobei der jeweilige Ausleger (3) mit einem ersten Ende (8) des Auslegers (3) an einer Ankerstruktur (7) befestigt ist und mit einem zweiten Ende (9) des Auslegers (3) über ein Federelement (5) mit der Kopplungsplatte (4) verbunden ist.

3. Mikromechanischer Ultraschallwandler (1) nach Anspruch 1 oder 2, wobei, in einer Draufsicht der Membran (2), die Ausleger (3) durch Schlitze (6) voneinander getrennt sind.

4. Mikromechanischer Ultraschallwandler (1) nach einem der Ansprüche 1 bis 3, wobei der jeweilige Ausleger (3) an einen der Aktoren gekoppelt ist, wobei der Aktor dafür gestaltet ist, zwischen einer elastischen Verformung, insbesondere einer Vibration, des Auslegers (3) und einem elektrischen Steuersignal, die einander entsprechen, zu übertragen.

5. Mikromechanischer Ultraschallwandler (1) nach einem der Ansprüche 1 bis 4, wobei die Kopplungsplatte (4) an einen der Aktoren gekoppelt ist, wobei der Aktor dafür gestaltet ist, zwischen einer elastischen Verformung, insbesondere einer Vibration, der Kopplungsplatte (4) und einem elektrischen Steuersignal, die einander entsprechen, zu übertragen.

6. Mikromechanischer Ultraschallwandler (1) nach einem der Ansprüche 1 bis 5, wobei der jeweilige Aktor mit einem piezoelektrischen Element geformt ist.

7. Mikromechanischer Ultraschallwandler (1) nach einem der Ansprüche 1 bis 6, wobei die Membran (2) auf einem Hohlraum (11) des Wandlers (1) angeordnet ist.

8. Mikromechanischer Ultraschallwandler (1) nach einem der Ansprüche 1 bis 7, wobei die Kopplungsplatte (4) eine veränderliche Massenverteilung zum Trägheitsausgleich aufweist, so dass bei Anwendung ein innerer Bereich der Kopplungsplatte (4) in Bezug auf eine Radialrichtung der Kopplungsplatte (4) und ein äußerer Bereich der Kopplungsplatte (4) in entgegengesetzten Richtungen geschwenkt werden.

9. Mikromechanischer Ultraschallwandler (1) nach einem der Ansprüche 1 bis 8, wobei die Kopplungsplatte (4) Gewichtselemente (13) zum Trägheitsausgleich auf einer vorderen Seite und/oder hinteren Seite der Kopplungsplatte (4), insbesondere in einem Kantenbereich der Kopplungsplatte (4), aufweist, wobei die Gewichtselemente (13) vorzugsweise regelmäßig voneinander beabstandet entlang einer Kantenrichtung um die Kopplungsplatte (4) angeordnet sind.

10. Mikromechanische Ultraschallwandleranordnung (12), die eine Vielzahl von mikromechanischen Ultraschallwandlern (1) nach einem der Ansprüche 1 bis 9 umfasst, wobei die Wandler (1) ein gemeinsames Substrat umfassen, vorzugsweise, wobei die Membranen (2) der Wandler (1) in Reihen oder in der Form einer geschlossenen Linie auf dem Substrat angeordnet sind.

11. Verfahren zum Betreiben eines mikromechanischen Ultraschallwandlers (1) nach einem der Ansprüche 1 bis 9 oder einer mikromechanischen Ultraschallwandleranordnung (12) nach Anspruch 10, wobei an dem jeweiligen Wandler (1) ein elektrisches Steuersignal an den mindestens einen Aktor angelegt wird, um mit der Membran (2) eine Ultraschallwelle zu erzeugen, oder ein elektrisches Steuersignal von dem mindestens einen Aktor ausgegeben wird, um mit der Membran (2) eine Ultraschallwelle zu erfassen.

12. Verfahren nach Anspruch 11, wobei mit Steuern der Aktoren (10), insbesondere mit Antreiben eines der Aktoren, die an einen Ausleger (3) gekoppelt sind, und Antreiben eines der Aktoren, die an die Kopplungsplatte (4) gekoppelt sind, eine Neigungsauslenkung der Kopplungsplatte (4) angepasst wird.

13. Verfahren nach Anspruch 11 oder 12, wobei periodische elektrische Steuersignale an die Aktoren (10) angelegt werden, die an die Ausleger (3) gekoppelt sind, wobei elektrische Steuersignale von Aktoren (10) unterschiedlicher Ausleger (3) eine Phasendifferenz aufweisen.

14. Verfahren zum Herstellen eines mikromechanischen Ultraschallwandlers (1), wobei mit dem Anordnen verschiedener Schichten, insbesondere dünner Schichten, aufeinander, wobei die Schichten durch das Formen eines strukturierten Musters umgesetzt werden, ein mikromechanischer Ultraschallwandler (1) nach einem der Ansprüche 1 bis 9 gebildet wird.

## Revendications

1. Transducteur ultrasonore micromécanique (1) pour la génération d'ondes ultrasonores ou la détection d'ondes ultrasonores, dans lequel le transducteur ultrasonore (1) comprend une membrane (2) et au moins un actionneur pour l'émission ou la détection d'ultrasons, dans lequel l'actionneur est conçu pour effectuer un transfert entre une déformation élastique, en particulier une vibration, de la membrane (2) et un signal de commande électrique correspondant l'un à l'autre, dans lequel la membrane (2) comprend une plaque d'accouplement (4) et une pluralité de structures en porte-à-faux (3) disposées autour de la plaque d'accouplement (4), dans lequel les structures en porte-à-faux (3) sont reliées à la plaque d'accouplement (4), de préférence par le biais d'éléments de ressort (5), de sorte que la déformation élastique des structures en porte-à-faux (3) permet d'exciter une vibration de la plaque d'accouplement (4), **caractérisé en ce que** des structures en porte-à-faux (3) respectivement adjacentes le long d'une circonférence autour de la plaque d'accouplement (4) se chevauchent entre elles dans des sections dans la direction radiale de la plaque d'accouplement (4).

2. Transducteur ultrasonore micromécanique (1) selon la revendication 1, dans lequel la structure en porte-à-faux (3) respective est fixée par une première extrémité (8) de la structure en porte-à-faux (3) à une structure d'ancrage (7) et reliée par une deuxième extrémité (9) de la structure en porte-à-faux (3) à la plaque d'accouplement (4) par le biais d'un élément de ressort (5).

3. Transducteur ultrasonore micromécanique (1) selon la revendication 1 ou 2, dans lequel, dans une vue de dessus de la membrane (2), les structures en porte-à-faux (3) sont séparées les unes des autres par des fentes (6).

4. Transducteur ultrasonore micromécanique (1) selon l'une quelconque des revendications 1 à 3, dans lequel la structure en porte-à-faux (3) respective est accouplée à l'un des actionneurs, dans lequel l'actionneur est conçu pour effectuer un transfert entre une déformation élastique, en particulier une vibration, de la structure en porte-à-faux (3) et un signal de commande électrique correspondant l'un à l'autre.

5. Transducteur ultrasonore micromécanique (1) selon l'une quelconque des revendications 1 à 4, dans lequel la plaque d'accouplement (4) est accouplée à l'un des actionneurs, dans lequel l'actionneur est conçu pour effectuer un transfert entre une déformation élastique, en particulier une vibration, de la plaque d'accouplement (4) et un signal de commande électrique correspondant l'un à l'autre.

6. Transducteur ultrasonore micromécanique (1) selon l'une quelconque des revendications 1 à 5, dans lequel l'actionneur respectif est formé avec un élément piézoélectrique.

7. Transducteur ultrasonore micromécanique (1) selon l'une quelconque des revendications 1 à 6, dans lequel la membrane (2) est disposée sur une cavité (11) du transducteur (1).

8. Transducteur ultrasonore micromécanique (1) selon l'une quelconque des revendications 1 à 7, dans lequel la plaque d'accouplement (4) présente une répartition variable de la masse pour un équilibrage par inertie de sorte que pendant l'utilisation, une région intérieure de la plaque d'accouplement (4) par rapport à une direction radiale de la plaque d'accouplement (4) et une région extérieure de la plaque d'accouplement (4) sont pivotées dans des directions opposées.

9. Transducteur ultrasonore micromécanique (1) selon l'une quelconque des revendications 1 à 8, dans lequel la plaque d'accouplement (4) comporte des éléments de poids (13) pour l'équilibrage par inertie sur un côté avant et/ou un côté arrière de la plaque d'accouplement (4), en particulier dans une région de bord de la plaque d'accouplement (4), lesdits éléments de poids (13) étant de préférence disposés de manière à être espacés régulièrement les uns des autres le long d'une direction de bord autour de la plaque d'accouplement (4).

10. Réseau de transducteurs ultrasonores micromécaniques (12), comprenant une pluralité de transducteurs ultrasonores micromécaniques (1) selon l'une quelconque des revendications 1 à 9, dans lequel les transducteurs (1) comprennent un substrat commun, de préférence dans lequel les membranes (2) des transducteurs (1) sont disposées en rangées ou sous la forme d'une ligne fermée sur le substrat.

11. Procédé de fonctionnement d'un transducteur ultrasonore micromécanique (1) selon l'une quelconque des revendications 1 à 9 ou d'un ensemble de transducteurs ultrasonores micromécaniques (12) selon la revendication 10, dans lequel, au niveau du transducteur (1) respectif, un signal de commande électrique est appliqué à l'au moins un actionneur afin de générer une onde ultrasonore avec la membrane (2) ou un signal de commande électrique est émis à partir de l'au moins un actionneur afin de détecter une onde ultrasonore avec la membrane (2).

12. Procédé selon la revendication 11, dans lequel une déflexion d'inclinaison de la plaque d'accouplement (4) est ajustée, en particulier commandée, avec la commande des actionneurs (10), en particulier avec l'entraînement de l'un des actionneurs accouplés à une structure en porte-à-faux (3) et l'entraînement de l'un des actionneurs accouplés à la plaque d'accouplement (4).

13. Procédé selon la revendication 11 ou 12, dans lequel des signaux de commande électriques périodiques sont appliqués aux actionneurs (10) accouplés aux structures en porte-à-faux (3), dans lequel des signaux de commande électriques d'actionneurs (10) de différentes structures en porte-à-faux (3) présentent une différence de phase.

14. Procédé de fabrication d'un transducteur ultrasonore micromécanique (1), dans lequel un transducteur ultrasonore micromécanique (1) selon l'une quelconque des revendications 1 à 9 est formé en disposant plusieurs couches, en particulier des couches fines, les unes sur les autres, dans lequel les couches sont réalisées de manière à former une configuration structurée.
